# DEMANDE DE BREVET EUROPEEN

(11) **EP 0 660 088 A1**
(43) Date de publication de la demande: **28.06.1995**
(21) Numéro de dépôt: 94402943.8
(22) Date de dépôt: 20.12.1994
(51) Int. Cl.: G01D 11/24, G01R 1/18

(54) **Dispositif indicateur à aiguille et élément moteur à commande électro-magnétique comportant un blindage magnétique**

(30) Priorité: 22.12.1993 FR 9315449
(71) Demandeur: MAGNETI MARELLI FRANCE, F-92000 Nanterre (FR)
(72) Inventeur: Lazareff, André, F-92110 Clichy (FR); Delhovren, Christophe, F-80000 Amiens (FR)
(74) Mandataire: Martin, Jean-Jacques

(57) **Abrégé**

La présente invention concerne un dispositif indicateur à aiguille comprenant un élément moteur à commande électromagnétique qui comporte : un ensemble à bobines de commande, un bati en matériau électriquement isolant (120) qui porte l'ensemble à bobines, et un blindage magnétique (100) qui entoure au moins partiellement l'ensemble à bobines et le bati support (120), et qui est composé d'une jupe périphérique (102) solidaire d'une cloison de fond transversale (104), caractérisé par le fait que : le bati support (120) comporte sur sa face arrière adjacente à la cloison de fond (104) du blindage (100), au moins un bossage (122) en saillie, et le blindage (100) comporte, dans sa dite cloison de fond (104), au moins une ouverture (110) de section généralement complémentaire dudit bossage (122), adaptée pour recevoir celui-ci, et qui comporte sur sa périphérie, au moins une patte (118) en saillie conçue pour être chassée sur ce bossage (122).

## Description

La présente invention concerne le domaine des dispositifs indicateurs à aiguille et élément moteur à commande électromagnétique.

Elle s'applique en particulier aux dispositifs indicateurs connus sous le nom de "logomètres".

On sait que les logomètres comprennent généralement :
- deux bobines de commande croisées à 90°,
- un aimant à aimantation radiale monté à rotation dans une chambre interne définie par lesdites bobines,
- un arbre lié à l'aimant et coaxial à celui-ci, adapté pour recevoir le moyeu d'une aiguille, et
- un blindage magnétique qui entoure au moins partiellement les bobines.

Le plus souvent, les bobines de commande sont portées par un bati support en matière plastique.

L'aimant s'oriente selon la résultante des champs magnétiques créés par les deux bobines.

Ainsi si les deux bobines sont alimentées par des signaux représentant les sinus/cosinus ou la tangente d'une grandeur d'entrée, l'orientation angulaire de l'aimant, par rapport à une position de référence, est directement représentative de cette grandeur d'entrée.

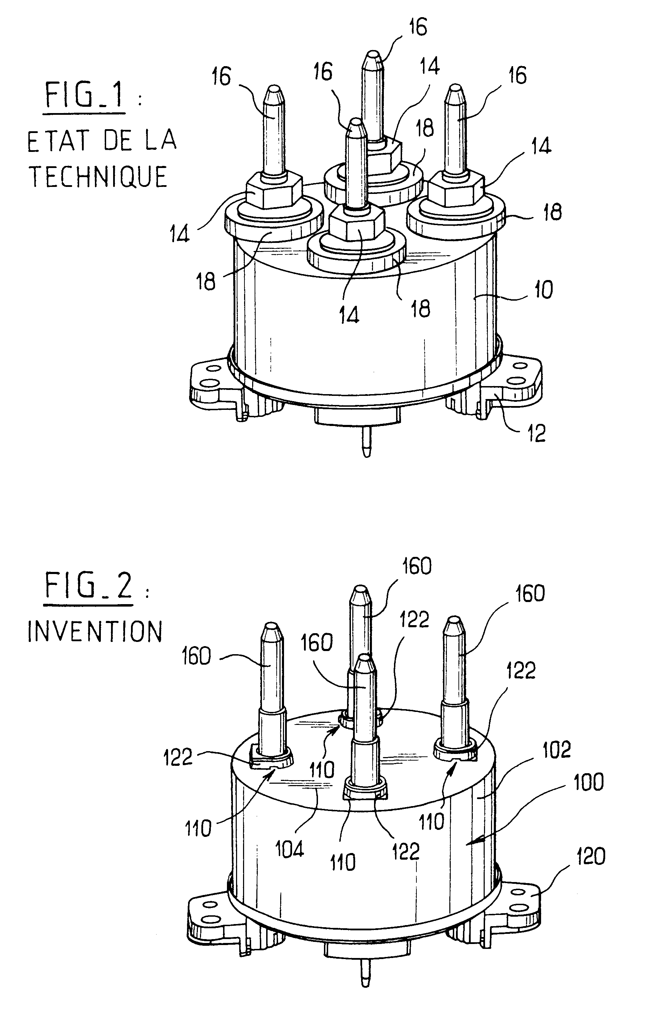

Comme on l'a représenté sur la figure 1, jusqu'ici les blindages magnétiques 10, formés d'une cloche cylindrique en métal, ont été fixés sur le bati support 12 des logomètres à l'aide d'écrous 14 serrés sur une partie filetée des broches d'alimentation 16 des bobines, avec interposition de rondelles 18 en matériau électriquement isolant.

La présente invention a maintenant pour but de perfectionner les dispositifs indicateurs connus du type précité.

Ce but est atteint dans le cadre de la présente invention grâce à un dispositif indicateur à aiguille comprenant un élément moteur à commande électromagnétique qui comporte :
- un ensemble à bobines de commande,
- un bati en matériau électriquement isolant qui porte l'ensemble à bobines, et
- un blindage magnétique qui entoure au moins partiellement l'ensemble à bobines et le bati support, et qui est composé d'une pièce périphérique solidaire d'une cloison de fond transversale, caractérisé par le fait que :
- le bati support comporte sur sa face arrière adjacente à la cloison de fond du blindage, au moins un bossage en saillie, et
- le blindage comporte, dans sa dite cloison de fond, au moins une ouverture de section généralement complémentaire dudit bossage, adaptée pour recevoir celui-ci, et qui comporte sur sa périphérie, au moins une patte en saillie conçue pour être chassée sur ce bossage.

D'autres caractéristiques, buts et avantages de la présente invention apparaîtront à la lecture de la description détaillée qui va suivre, et en regard des dessins annexés donnés à titre d'exemple non limitatif et sur lesquels :
- la figure 1 précédemment décrite représente une vue en perspective d'un logomètre conforme à l'état de la technique,
- la figure 2 représente une vue similaire en perspective d'un logomètre conforme à la présente invention,
- la figure 3 représente une vue en plan arrière d'un blindage magnétique d'un logomètre conforme à la présente invention,
- la figure 4 représente une vue en coupe longitudinale du même blindage selon le plan de coupe référencé IV-IV sur la figure 3,
- la figure 5 représente une vue schématique agrandie du détail référencé V sur la figure 4,
- la figure 6 représente une vue agrandie d'une découpe ménagée dans la cloison de fond du blindage comme illustré en VI sur la figure 3, et
- la figure 7 représente une demi-vue à échelle agrandie d'une variante de réalisation d'une telle ouverture.

La structure générale interne du logomètre comprenant des bobines, un aimant et un arbre porteur d'aiguille, connue en soi, ne sera pas décrite par la suite.

On notera simplement que l'on aperçoit sur la figure 2 annexée, le bati support 120 réalisé de préférence par moulage en matière plastique et quatre broches 160 accessibles à l'arrière du logomètre et conçues pour assurer l'alimentation des bobines électriques internes.

Le blindage 100 est également de structure générale connue. Il comprend une jupe périphérique cylindrique 102 solidaire d'une cloison de fond 104, en forme de disque, transversale à l'axe de la jupe périphérique 102. Le blindage 100 est réalisé avantageusement en métal magnétique doux, par exemple par emboutissage d'une feuille d'acier doux, avantageusement protégée contre la corrosion, par exemple par nickelage.

Comme on l'a indiqué précédemment, selon l'invention, la cloison de fond 104 du blindage 100 comprend au moins une découpe 110 conçue pour recevoir un bossage 122 venu de moulage sur la paroi arrière du bati support 120.

Selon le mode de réalisation préférentiel représenté sur les figures annexées, chaque bossage 122 venu de moulage sur la face arrière du bati support 120 possède un canal interne central apte à recevoir, par exemple par chassage, l'une des broches 160. Ainsi comme on le voit sur la figure 2, lesdits bossages 122 sont prévus à la base des broches d'alimentation 160.

De préférence, les bossages 122 et ouvertures 110 présentent des sections non symétriques de révolution.

Selon le mode de réalisation préférentiel représenté sur les figures annexées, chaque bossage 122 présente en section droite, c'est-à-dire perpendiculairement à l'axe du logomètre, une section délimitée par une calotte hémicylindrique, deux plans principaux parallèles entre eux qui se raccordent tangentiellement sur les extrémités de la calotte hémicylindrique précitée, et un plan auxiliaire orthogonal aux deux plans principaux, la calotte hémicylindrique, les deux plans principaux et le plan auxiliaire étant délimités par des génératrices parallèles à l'axe du logomètre.

Les ouvertures 110 ménagées dans la cloison de fond 104 du blindage présentent des sections identiques. C'est-à-dire que les ouvertures 110 sont délimitées avantageusement par une calotte hémicylindrique 112, deux plans principaux 114, 116 parallèles entre eux qui se raccordent tangentiellement sur les extrémités de la calotte 112 et un plan auxiliaire 113 perpendiculaire aux plans principaux 114, 116, lesquels calottes 112 et plans 114, 116 et 113 sont délimités par des génératrices parallèles à l'axe du logomètre.

Par ailleurs, selon l'invention, chaque ouverture 110 est pourvue sur sa périphérie interne d'au moins une patte 118, en saillie, conçue pour être chassée sur la périphérie extérieure d'un bossage 122 associé.

Plus précisément, dans le cadre de l'invention, chaque ouverture 110 est pourvue de préférence de deux pattes 118 sensiblement diamétralement opposées par rapport au centre de l'ouverture 110.

Ces pattes 118 sont prévues de préférence au niveau de la zone de raccordement entre les extrémités de la calotte hémicylindrique 112 et les plans principaux 114, 116 qui lui sont raccordés.

La hauteur des bossages 122, considérée parallèlement à l'axe du logomètre doit être supérieure à l'épaisseur de la paroi de fond 110 du blindage 100.

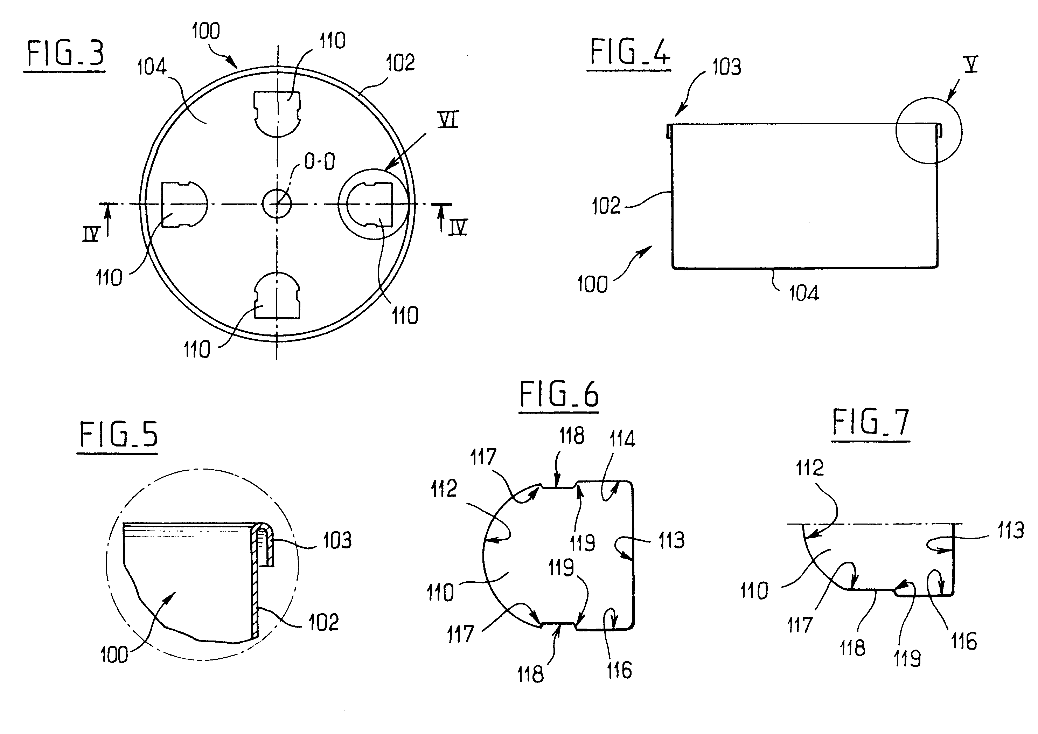

Comme représenté sur la figure 6 annexée, les deux extrémités 117, 119 de chaque patte 118 peuvent se raccorder sur la périphérie interne de la découpe 110 par l'intermédiaire de décrochements. Ou encore, selon la variante représentée sur la figure 7, l'une des extrémités 119 de chaque patte 118, de préférence celle adjacente aux plans principaux 114, 116, se raccorde par l'intermédiaire d'un décrochement sur la périphérie interne de la découpe 110, tandis que l'autre extrémité 117 de chaque patte 118 se raccorde tangentiellement sur la périphérie interne de l'ouverture 110.

Selon le mode de réalisation particulier représenté sur les figures annexées, il est prévu dans le cadre de l'invention quatre ouvertures 110 et bossages 122 complémentaires équi-répartis autour de l'axe central O-O du logomètre.

On notera en outre, que dans le cadre de l'invention, de préférence le bord libre 103 de la jupe périphérique 102 du blindage 100 est roulé vers l'extérieur. Cette disposition permet de garantir une géométrie parfaitement circulaire au blindage 100 et évite par conséquent la formation de distortion magnétique.

On notera que les bossages 122 permettent d'isoler les broches 160 entre elles, et d'isoler en outre celles-ci du blindage magnétique 100 généralement électriquement conducteur.

Pour assembler le logomètre conforme à la présente invention, après la mise en place des bobines et de l'aimant sur le bati support 120, il suffit d'engager celui-ci dans le blindage 100, jusqu'à chassage des pattes 118 sur l'enveloppe externe des bossages complémentaires 122.

On notera que la présente invention offre en particulier, par rapport à l'état de la technique les avantages d'un maintien économique et automatisable du blindage, tout en assurant la qualité de celui-ci, sans déformation circulaire risquant d'entraîner une distortion magnétique.

Bien entendu la présente invention n'est pas limitée au mode de réalisation particulier qui vient d'être décrit mais s'étend à toute variante conforme à son esprit.

Il faut noter que la présente invention permet d'utiliser des broches 160 lisses, c'est à dire dépourvues de filetage. De ce fait la présente invention permet d'opérer des économies substantielles par rapport aux dispositifs classiques. Les dispositifs indicateurs conformes à la présente invention peuvent être fixés par tous moyens classiques appropriés, par exemple à l'aide de soudures, agrafes ou équivalents, venant en prise par exemple avec les broches 160.

## Revendications

1. Dispositif indicateur à aiguille comprenant un élément moteur à commande électromagnétique qui comporte :
- un ensemble à bobines de commande,
- un bati en matériau électriquement isolant (120) qui porte l'ensemble à bobines, et
- un blindage magnétique (100) qui entoure au moins partiellement l'ensemble à bobines et le bati support (120), et qui est composé d'une jupe périphérique (102) solidaire d'une cloison de fond transversale (104),
caractérisé par le fait que :
- le bati support (120) comporte sur sa face arrière adjacente à la cloison de fond (104) du blindage (100), au moins un bossage (122) en saillie, et
- le blindage (100) comporte, dans sa dite cloison de fond (104), au moins une ouverture (110) de section généralement complémentaire dudit bossage (122), adaptée pour recevoir celui-ci, et qui comporte sur sa périphérie, au moins une patte (118) en saillie conçue pour être chassée sur ce bossage (122).

2. Dispositif selon la revendication 1, caractérisé par le fait que le blindage comporte dans sa cloison de fond (104) plusieurs ouvertures (110) et que le bati support (120) comporte plusieurs bossages (122) respectivement complémentaires.

3. Dispositif selon la revendication 2, caractérisé par le fait que lesdites ouvertures (110) et lesdits bossages (122) prévus respectivement sur le blindage (100) et sur le bati support (120) sont équi-répartis autour de l'axe du logomètre.

4. Dispositif selon l'une des revendications 1 à 3, caractérisé par le fait que chaque ouverture (110) comporte plusieurs pattes (118) en saillie sur sa périphérie interne.

5. Dispositif selon l'une des revendications 1 à 4, caractérisé par le fait que chaque ouverture (110) possède deux pattes (118) sensiblement diamétralement opposées par rapport au centre de l'ouverture.

6. Dispositif selon l'une des revendications 1 à 5, caractérisé par le fait que chaque ouverture (110) est de section non symétrique de révolution.

7. Dispositif selon l'une des revendications 1 à 6, caractérisé par le fait que chaque ouverture (110) et/ou bossage (122) est délimitée par une calotte hémicylindrique (112), deux plans principaux (114, 116) parallèles entre eux et raccordés tangentiellement sur les extrémités de la calotte hémicylindrique (112) et un plan auxiliaire (113) perpendiculaire aux plans principaux (114, 116) et qui raccorde ceux-ci.

8. Dispositif selon l'une des revendications 1 à 7, caractérisé par le fait que chaque patte (118) se raccorde par l'intermédiaire de deux décrochements (117, 119) sur la périphérie interne de l'ouverture associée (110).

9. Dispositif selon l'une des revendications 1 à 7, caractérisé par le fait que chaque patte (118) se raccorde par l'intermédiaire d'un décrochement (119) sur la périphérie interne de l'ouverture associée (110).

10. Dispositif selon la revendication 7, caractérisé par le fait que chaque patte (118) est prévue au niveau de la zone de raccordement de la calotte hémicylindrique (112) sur les plans principaux (114, 116).

11. Dispositif selon l'une des revendications 1 à 10, caractérisé par le fait que chaque bossage (122) présente un canal interne apte à recevoir une broche (160) d'alimentation de l'ensemble à bobine.

12. Dispositif selon l'une des revendications 1 à 11, caractérisé par le fait que la hauteur de chaque bossage (122) est supérieure à l'épaisseur de la paroi de fond du blindage (100).

13. Dispositif selon l'une des revendications 1 à 12, caractérisé par le fait que le bord libre (103) de la jupe périphérique (102) du blindage (100) est roulé vers l'extérieur.
